# EUROPEAN PATENT APPLICATION

(11) **EP 4 836 185 A1**
(43) Date of publication of application: **04.11.2026**
(21) Application number: 25192512.9
(22) Date of filing: 29.07.2025
(51) Int. Cl.: H01Q 1/02, H01L 23/427, H05K 7/20, H01Q 1/24

(54) **ANTENNA DEVICE**

(30) Priority: 29.04.2025 TW 114116037
(71) Applicant: Auden Techno Corp., Taoyuan City 334 (TW)
(72) Inventor: LIAO, Yi-Ping, 334 Taoyuan City (TW)
(74) Representative: Viering, Jentschura & Partner mbB Patent- und Rechtsanwälte

(57) **Abstract**

An antenna device (100) includes a housing (1), a receiving unit (2), a transmitting unit (3), and a heat dissipation module (4). The receiving and the transmitting unit (3) are disposed in the housing (1) and spaced apart from each other. The heat dissipation module (4) is disposed in the housing (1) and located on a common side of the receiving and the transmitting unit (3). The heat dissipation module (4) includes two metal heat dissipation components (41) and two temperature equalizing plates (42). The metal heat dissipation components (41) have two cavity structures (GS) corresponding in position to the receiving and the transmitting unit (3). Two projection regions defined by orthogonally projecting the cavity structures (GS) along a thickness direction (D1) of the housing (1) toward the receiving and the transmitting unit (3) cover integrated circuit configuration regions of the receiving and the transmitting unit (3). The temperature equalizing plates (42) are respectively disposed in the cavity structures (GS) and in contact with the receiving and the transmitting unit (3).

## Description

### FIELD OF THE INVENTION

The present invention relates to a device, and more particularly to an antenna device.

### BACKGROUND OF THE INVENTION

In order to meet the wireless communication needs such as coverage area expansion and network stability, a conventional antenna device that is portable (i.e., a ground base station) has been designed. However, under the requirement of portability, a size of the conventional antenna device is limited. Therefore, how the heat generated during operation of the conventional antenna device can be effectively dissipated within a limited volume is an important aspect in the relevant industry. The conventional antenna device relies on aluminum extrusions for passive heat dissipation, but the cooling effect thereof is limited.

### SUMMARY OF THE INVENTION

In response to the above-referenced technical inadequacy, the present invention provides an antenna device.

In order to solve the above-mentioned problems, one of the technical aspects adopted by the present invention is to provide an antenna device. The antenna device includes a housing, a receiving unit, a transmitting unit, and a heat dissipation module. The housing has a thickness direction. The receiving unit and the transmitting unit are disposed in the housing and spaced apart from each other. The heat dissipation module is disposed in the housing and is located on a common side of the receiving unit and the transmitting unit. The heat dissipation module includes two metal heat dissipation components and two temperature equalizing plates. Each of the two metal heat dissipation components has two cavity structures. The two cavity structures respectively correspond in position to the receiving unit and the transmitting unit, and one of two projection regions defined by orthogonally projecting one of the two cavity structures along the thickness direction toward the receiving unit and another one of the two projection regions defined by orthogonally projecting another one of the two cavity structures along the thickness direction toward the transmitting unit cover a first integrated circuit configuration region of the receiving unit and a second integrated circuit configuration region of the transmitting unit. The two temperature equalizing plates are respectively disposed in the two cavity structures. The two temperature equalizing plates are in contact with the receiving unit and the transmitting unit, respectively.

Therefore, in the antenna device provided by the present invention, by virtue of "the two cavity structures respectively corresponding in position to the receiving unit and the transmitting unit, and one of two projection regions defined by orthogonally projecting one of the two cavity structures along the thickness direction toward the receiving unit and another one of the two projection regions defined by orthogonally projecting another one of the two cavity structures along the thickness direction toward the transmitting unit covering a first integrated circuit configuration region of the receiving unit and a second integrated circuit configuration region of the transmitting unit," and "the two temperature equalizing plates respectively being disposed in the two cavity structures, and the two temperature equalizing plates being in contact with the receiving unit and the transmitting unit, respectively," the antenna device can be capable of performing effective heat dissipation within a miniaturized volume (i.e., a limited volume).

These and other aspects of the present invention will become apparent from the following description of the embodiment taken in conjunction with the following drawings and their captions, although variations and modifications therein may be affected without departing from the spirit and scope of the novel concepts of the invention.

### BRIEF DESCRIPTION OF THE DRAWINGS

The described embodiments may be better understood by reference to the following description and the accompanying drawings, in which:
FIG. 1 is a schematic perspective view of an antenna device according to the present invention;
FIG. 2 is another schematic perspective view of the antenna device according to the present invention;
FIG. 3 is a schematic exploded view of the antenna device according to the present invention;
FIG. 4 is another schematic exploded view of the antenna device according to the present invention;
FIG. 5 is a schematic cross-sectional view taken along line V-V of FIG. 1;
FIG. 6 is a schematic enlarged view of section VI of FIG. 5;
FIG. 7 is a schematic exploded view of a heat dissipation module according to the present invention;
FIG. 8 is a schematic enlarged view of section VIII of FIG. 3; and
FIG. 9 is a schematic perspective view of an active heat exchanger in FIG. 7 that separates a short heat dissipation fin assembly according to the present invention.

### DETAILED DESCRIPTION OF THE EXEMPLARY EMBODIMENTS

The present invention is more particularly described in the following examples that are intended as illustrative only since numerous modifications and variations therein will be apparent to those skilled in the art. Like numbers in the drawings indicate like components throughout the views. As used in the description herein and throughout the claims that follow, unless the context clearly dictates otherwise, the meaning of "a," "an" and "the" includes plural reference, and the meaning of "in" includes "in" and "on." Titles or subtitles can be used herein for the convenience of a reader, which shall have no influence on the scope of the present invention.

The terms used herein generally have their ordinary meanings in the art. In the case of conflict, the present document, including any definitions given herein, will prevail. The same thing can be expressed in more than one way. Alternative language and synonyms can be used for any term(s) discussed herein, and no special significance is to be placed upon whether a term is elaborated or discussed herein. A recital of one or more synonyms does not exclude the use of other synonyms. The use of examples anywhere in this specification including examples of any terms is illustrative only, and in no way limits the scope and meaning of the present invention or of any exemplified term. Likewise, the present invention is not limited to various embodiments given herein. Numbering terms such as "first," "second" or "third" can be used to describe various components, signals or the like, which are for distinguishing one component/signal from another one only, and are not intended to, nor should be construed to impose any substantive limitations on the components, signals or the like.

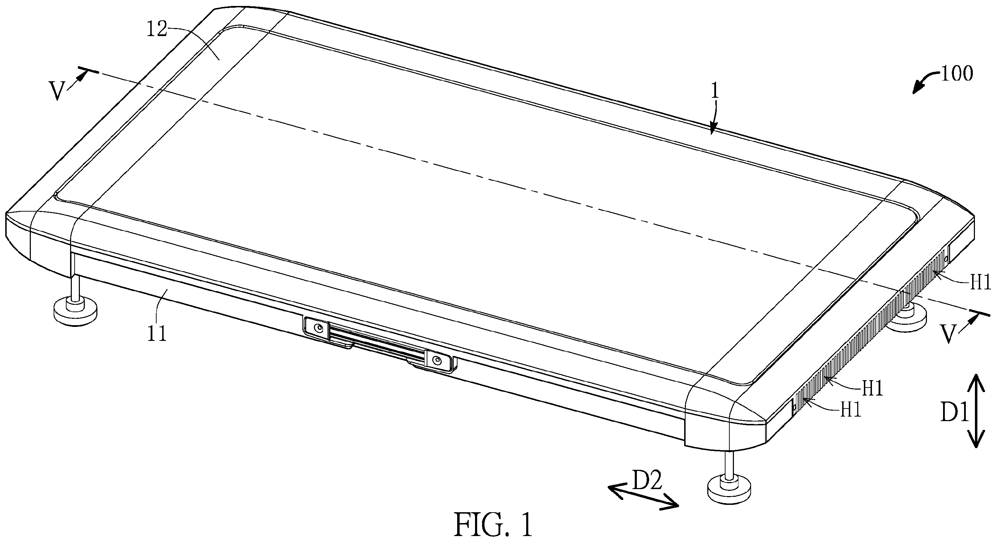

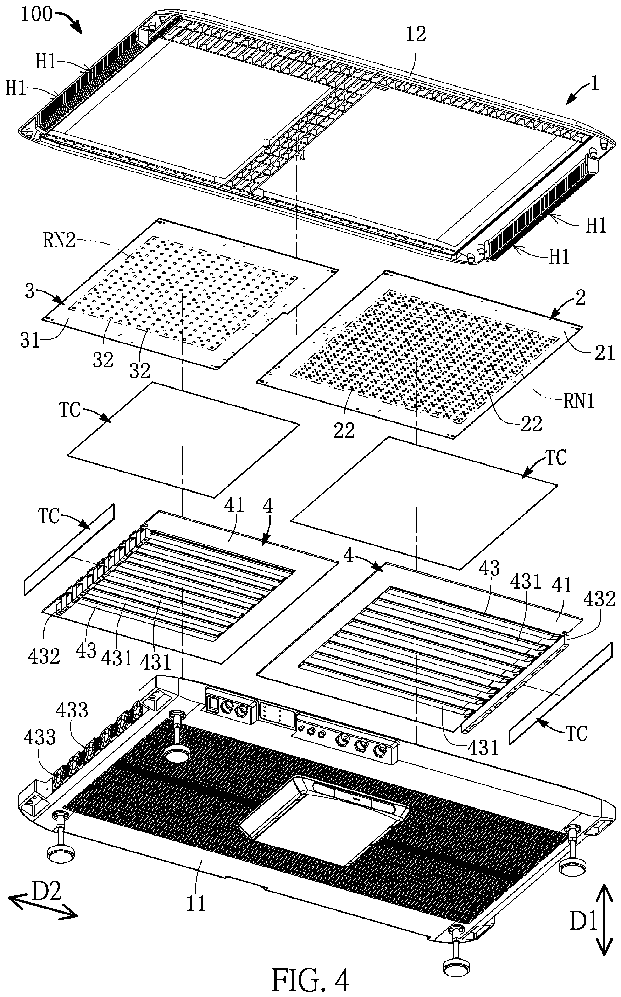

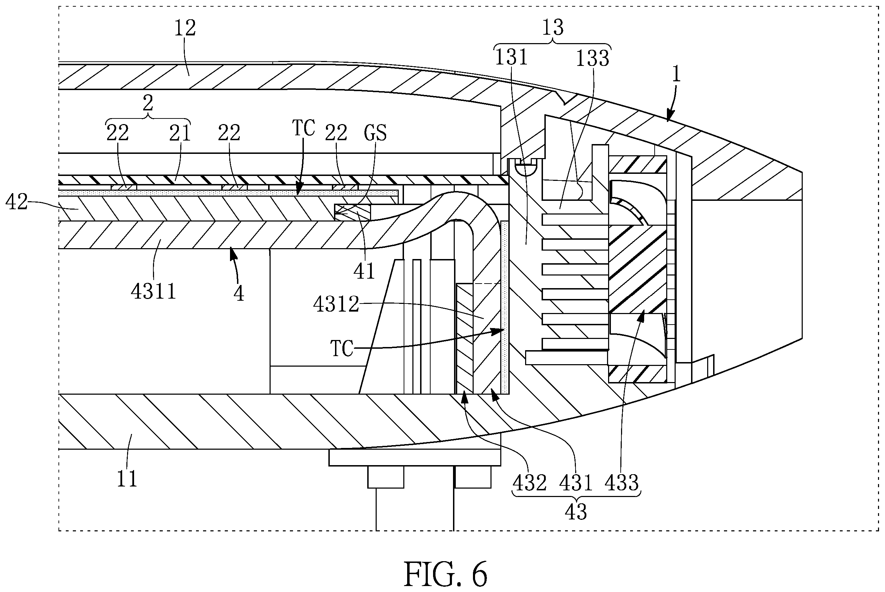

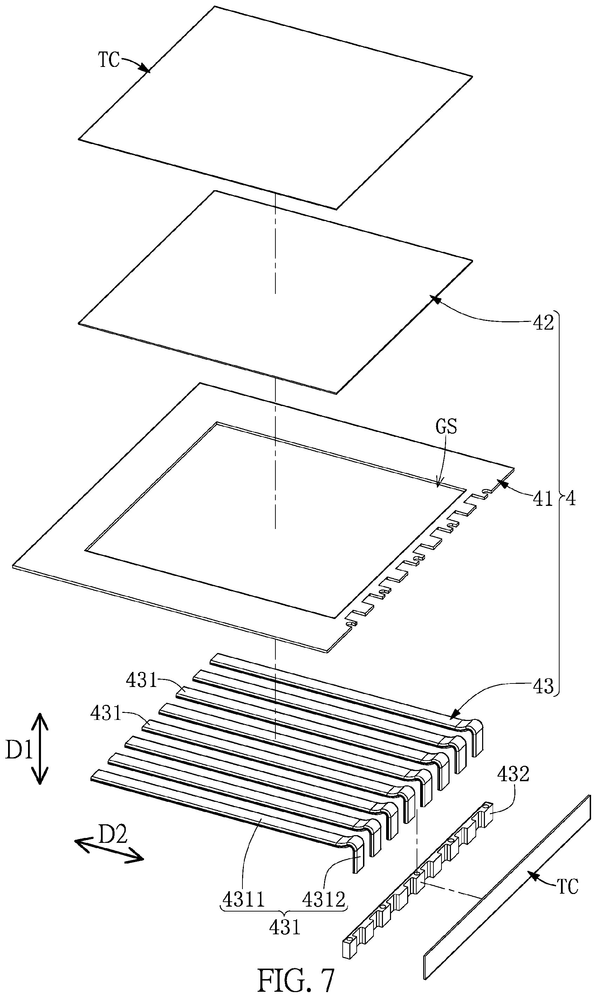

Referring to FIG. 1 to FIG. 9, the present invention provides an antenna device 100. As shown in FIG. 1 to FIG. 3, the antenna device 100 includes a housing 1, a receiving unit 2 and a transmitting unit 3 disposed in the housing 1, and a heat dissipation module 4 that is contacted to the receiving unit 2 and the transmitting unit. The following description describes the structure and connection relation of each component of the antenna device 100.

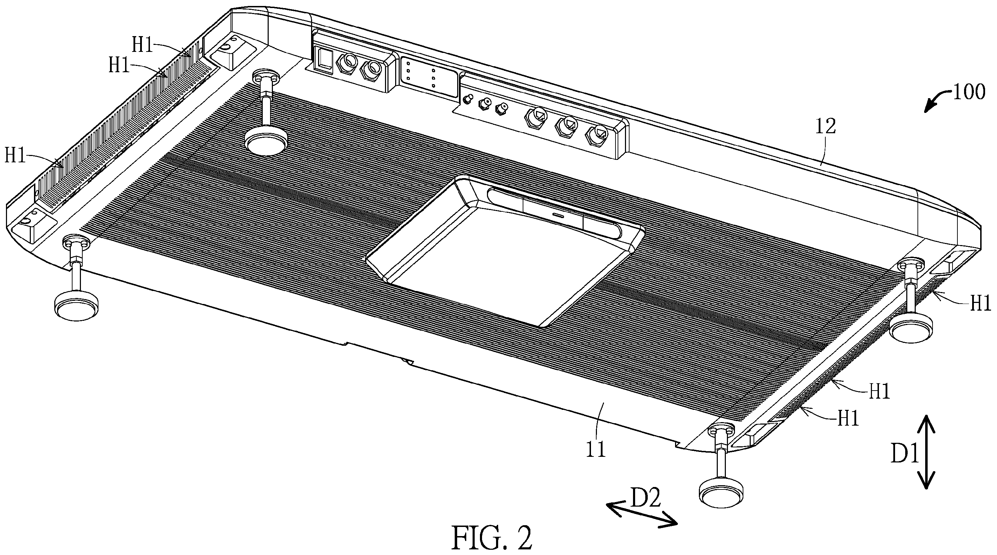

Referring to FIG. 2 to FIG. 4, in the present embodiment, the housing 1 is substantially a flat plate structure, and the housing 1 has a thickness direction D1 and a width direction D2 perpendicular to the thickness direction D1. Specifically, in the cross-sectional view of the housing 1 along the thickness direction D1, a thickness of a middle portion of the housing 1 is greater than a thickness of two ends of the housing 1, meaning that the housing 1 in the present embodiment is a flat plate structure with a "thick middle portion and thin ends" along the width direction, but the present invention is not limited herein.

Preferably, the housing 1 further includes a plurality of heat dissipation holes H1 that are arranged at the two ends of the housing 1, the heat dissipation holes H1 are spaced apart from each other, and the heat dissipation holes H1 extend along the thickness direction D1. In other words, an extending direction of each of the heat dissipation holes H1 is parallel to the thickness direction D1.

It is worth noting that, in practice, the housing 1 may include a bottom cover 11 and an outer cover 12. The outer cover 12 covers the bottom cover 11, and the heat dissipation holes H1 are disposed at two ends of the outer cover 12 along the width direction D2. In addition, the housing 1 has two fin heat dissipation walls 13 made of heat dissipation material (e.g., thermally conductive plastic) that located at two ends of the bottom cover 11 corresponding in position to the heat dissipation holes H1. The two fin heat dissipation walls 13 are located on an inner side of the outer cover 12 to provide heat dissipation for the heat dissipation module 4.

Referring to FIG. 2 to FIG. 4, the receiving unit 2 and the transmitting unit 3 are used to implement the receiving and transmitting functions for wireless communication. In the present embodiment, the receiving unit 2 and the transmitting unit 3 are spaced apart from each other along the width direction D2. The receiving unit 2 has a first integrated circuit configuration region RN1 for configuring integrated circuits related to the receiving function, and the transmitting unit 3 has a second integrated circuit configuration region RN2 for configuring integrated circuits related to the transmitting function.

In practice, the receiving unit 2 includes a first carrier board 21 (e.g., a PCB board) and a plurality of first beamforming integrated circuits 22. A middle region of the first carrier board 21 serves as the first integrated circuit configuration region RN1, and the first beamforming integrated circuits 22 are disposed on the first integrated circuit configuration region RN1. Similarly, the transmitting unit 3 includes a second carrier board 31 (e.g., a PCB board) and a plurality of second beamforming integrated circuits 32. A middle region of the second carrier board 31 serves as the second integrated circuit configuration region RN2, and the second beamforming integrated circuits 32 are disposed on the second integrated circuit configuration region RN2.

Preferably, the first integrated circuit configuration region RN1 and the second integrated circuit configuration region RN2 are each rectangular, but are not limited to this shape in the present invention.

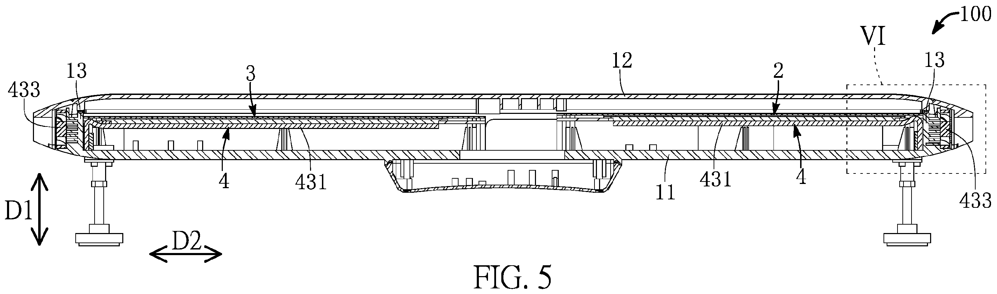

Referring to FIG. 5 to FIG. 7, the heat dissipation module 4 is disposed in the housing 1 and is located on a common side of the receiving unit 2 and the transmitting unit 3. The heat dissipation module 4 includes two metal heat dissipation components 41 and two temperature equalizing plates 42 for dissipating heat from the receiving unit 2 and the transmitting unit 3.

Specifically, the two metal heat dissipation components 41 can be exemplified to be annular plates made of aluminum, and central regions of the two metal heat dissipation components 41 respectively have two cavity structures GS. The two cavity structures GS respectively correspond in position to the receiving unit 2 and the transmitting unit 3, and one of two projection regions defined by orthogonally projecting one of the two cavity structures GS along the thickness direction D1 toward the receiving unit 2 and another one of the two projection regions defined by orthogonally projecting another one of the two cavity structures GS along the thickness direction D1 toward the transmitting unit 3 cover a first integrated circuit configuration region RN1 of the receiving unit 2 and a second integrated circuit configuration region RN2 of the transmitting unit 3. In other words, the two temperature equalizing plates 42 are respectively surrounded by inner sides of the two cavity structures GS, and the two temperature equalizing plates 42 respectively correspond in position to the first integrated circuit configuration region RN1 and the second integrated circuit configuration region RN2.

The two temperature equalizing plates 42 are respectively disposed in the two cavity structures GS, and the two temperature equalizing plates 42 are respectively in contact with the first beamforming integrated circuits 22 in the first integrated circuit configuration region RN1 and the second beamforming integrated circuits 32 in the second integrated circuit configuration region RN2. Accordingly, the two temperature equalizing plates 42 can absorb the heat generated by the first beamforming integrated circuits 22 and the second beamforming integrated circuits 32, and guide the heat to the two metal heat dissipation components 41 for heat dissipation.

In practice, in order to ensure that there is no air between each of the first beamforming integrated circuit 22 and a position corresponding to one of the two temperature equalizing plates 42, and between each of the second beamforming integrated circuit and a position corresponding to one of the two temperature equalizing plates 42, the best heat conduction efficiency can be ensured. The heat dissipation module 4 further includes two thermally conductive material layers TC, and the two temperature equalizing plates 42 are respectively connected to the first beamforming integrated circuits 22 of the receiving unit 2 and the second beamforming integrated circuits 32 of the transmitting unit 3 through the two thermally conductive material layers TC.

Preferably, top surfaces of the first beamforming integrated circuits 22 may be coplanar, so as to contact one of the two temperature equalizing plates 42 (through one of the two thermally conductive material layers TC). Similarly, top surfaces of the second beamforming integrated circuits 32 may also be coplanar, so as to contact another one of the two temperature equalizing plates 42 (through another one of the two thermally conductive material layers TC).

On the other hand, in order to improve the heat dissipation efficiency of the heat dissipation module 4, the heat dissipation module 4 may further include two heat pipe assemblies 43, and the heat dissipation module 4 is capable of better guiding heat through the two heat pipe assemblies 43, so as to direct the heat towards the heat dissipation holes H1 for effective cooling.

Specifically, the two heat pipe assemblies 43 are disposed on a common side of the two metal heat dissipation components 41 and the two temperature equalizing plates 42 away from the receiving unit 2 and the transmitting unit 3. The two heat pipe assemblies 43 respectively contact the two temperature equalizing plates 42, and a plurality of heat pipes 431 of the two heat pipe assemblies 43 are arranged along the width direction D2, so that end of each of the heat pipes 431 is adjacent to the heat dissipation holes H1.

It should be noted that, in practice, the structure of each of the heat pipes 431 may be an L-shaped structure, so that each of the heat pipes 431 includes a long section 4311 and a short section 4312 connected to the long section 4311. The long section 4311 extends along the width direction D2, and the long section 4311 is used to contact a corresponding one of the two temperature equalizing plates 42 to absorb heat energy. In addition, a connection end (not shown) of the long section 4311 adjacent to the heat dissipation holes H1 is used to connect to the short section 4312 extending along the thickness direction D1. Accordingly, each of the heat pipes 431 can increase an area that is adjacent to the heat dissipation holes H1 through the short section 4312, so as to improve heat dissipation efficiency.

In the present embodiment, a cross-section of each of the heat pipes 431 is rectangular, that is, each of the heat pipes 431 includes two wide side surfaces and two narrow side surfaces connected to the two wide side surfaces. One of the two wide side surfaces of each of the long sections 4311 can contact a corresponding one of the two temperature equalizing plates 42, and one of the wide side surfaces of each of the short sections 4312 is adjacent to the heat dissipation holes H1 for connecting to the fin heat dissipation wall 13.

Preferably, the two heat pipe assemblies 43 may also include two auxiliary heat dissipation components 432, and the two auxiliary heat dissipation components 432 may be respectively disposed on the two fin heat dissipation walls 13, and the short section 4312 of the each of the heat pipe 431 can contact a position corresponding to one of the two auxiliary heat dissipation components 432 at a corresponding position. In practice, each of the two auxiliary heat dissipation components 432 can be a plate-like structure including two wide side surfaces and two narrow side surfaces connected to the two wide side surfaces, and one of the two wide side surfaces faces the heat dissipation holes H1 that are located at one of the two ends of the housing 1, so as to connect to the fin heat dissipation wall 13. Thus, the heat pipes 431 can more effectively guide heat to the two auxiliary heat dissipation components 432, which then direct the heat to the two finned heat dissipation walls 13, further dissipating the heat through the multiple heat dissipation holes H1. Accordingly, the heat pipes 431 can more effectively guide heat energy to the two fin heat dissipation walls 13 via the two auxiliary heat dissipation components 432, so as to dissipate heat through the heat dissipation holes H1.

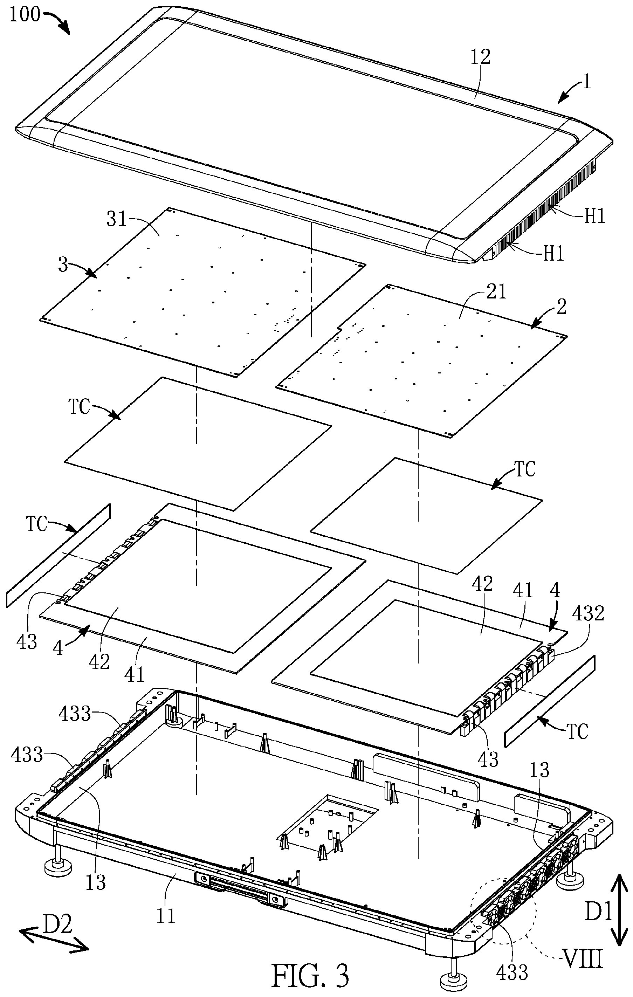

Naturally, as shown in FIG. 3, FIG. 4, and FIG. 6, the heat dissipation module 4 may also include a plurality of thermally conductive material layers TC, and the heat pipes 431 are connected to the two temperature equalizing plates 42 and the two auxiliary heat dissipation components 432 through the thermally conductive material layers TC.

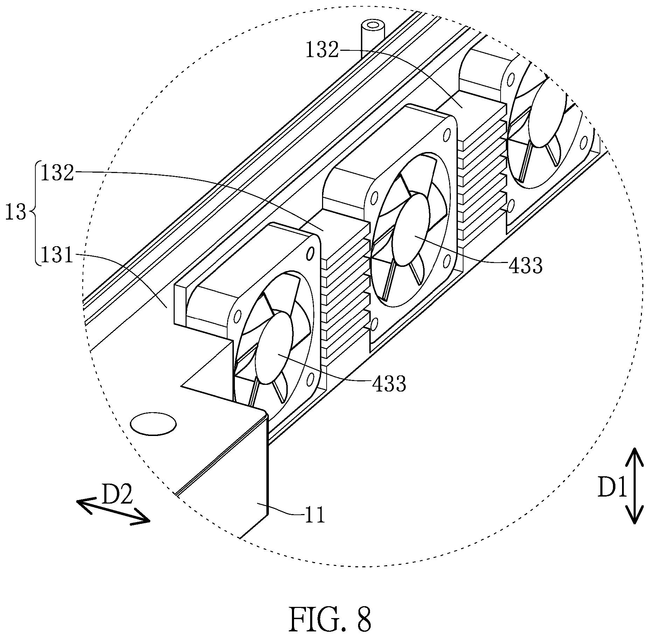

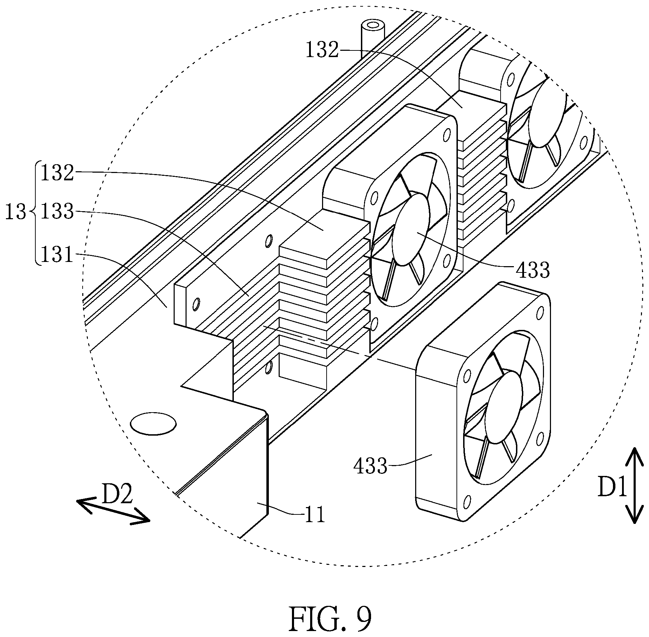

It should be noted that, as shown in FIG. 8 and FIG. 9, the antenna device 100 may also adopt active heat dissipation. Specifically, the two heat pipe assemblies 43 may further include a plurality of active heat exchangers 433 (e.g., fans), and the active heat exchangers 433 of the two heat pipe assemblies 43 respectively correspond in position to the heat dissipation holes H1 located at the two ends of the housing 1.

In practice, the active heat exchangers 433 are disposed on the two fin heat dissipation walls 13. Each of the two fin heat dissipation walls 13 includes a body 131, and a plurality of long heat dissipation fin assemblies 132 and a plurality of short heat dissipation fin assemblies 133 that are connected to the body 131.

The long heat dissipation fin assemblies 132 and the short heat dissipation fin assemblies 133 extend from the body 131 along the width direction D2, respectively. The long heat dissipation fin assemblies 132 and the short heat dissipation fin assemblies 133 face the heat dissipation holes H1. In addition, a length of each of the long heat dissipation fin assemblies 132 is greater than a length of each of the short heat dissipation fin assemblies 133. The long heat dissipation fin assemblies 132 and the short heat dissipation fin assemblies 133 are arranged in a staggered manner, that is, two of the long heat dissipation fin assemblies 132 are respectively arranged on both sides of each of the short heat dissipation fin assemblies 133. The active heat exchangers 433 are respectively disposed on the short heat dissipation fin assemblies 133, and two sides of each of the active heat exchangers 433 correspond in position to two of the long heat dissipation fin assemblies 132.

Thus, each of the two fin heat dissipation walls 13 has a larger heat dissipation area through the long heat dissipation fin assemblies 132 and the short heat dissipation fin assemblies 133, so as to cooperate with the active heat exchangers 433 to actively guide the heat energy to be discharged through the heat dissipation holes H1.

### [Beneficial Effects of the Embodiment]

In conclusion, in the antenna device provided by the present invention, by virtue of "the two cavity structures respectively corresponding in position to the receiving unit and the transmitting unit, and one of two projection regions defined by orthogonally projecting one of the two cavity structures along the thickness direction toward the receiving unit and another one of the two projection regions defined by orthogonally projecting another one of the two cavity structures along the thickness direction toward the transmitting unit covering a first integrated circuit configuration region of the receiving unit and a second integrated circuit configuration region of the transmitting unit," and "the two temperature equalizing plates respectively being disposed in the two cavity structures, and the two temperature equalizing plates being in contact with the receiving unit and the transmitting unit, respectively," the antenna device can be capable of performing effective heat dissipation within a miniaturized volume (i.e., a limited volume).

The foregoing description of the exemplary embodiments of the invention has been presented only for the purposes of illustration and description and is not intended to be exhaustive or to limit the invention to the precise forms disclosed. Many modifications and variations are possible in light of the above teaching.

The embodiments were chosen and described in order to explain the principles of the invention and their practical application so as to enable others skilled in the art to utilize the invention and various embodiments and with various modifications as are suited to the particular use contemplated.

## Claims

1. An antenna device (100), **characterized by** comprising:
a housing (1) having a thickness direction (D1);
a receiving unit (2) and a transmitting unit (3) disposed in the housing (1) and spaced apart from each other; and
a heat dissipation module (4) disposed in the housing (1) and located on a common side of the receiving unit (2) and the transmitting unit (3), wherein the heat dissipation module (4) includes:
two metal heat dissipation components (41), wherein each of the two metal heat dissipation components (41) has two cavity structures (GS), the two cavity structures (GS) respectively correspond in position to the receiving unit (2) and the transmitting unit (3), and one of two projection regions defined by orthogonally projecting one of the two cavity structures (GS) along the thickness direction (D1) toward the receiving unit (2) and another one of the two projection regions defined by orthogonally projecting another one of the two cavity structures (GS) along the thickness direction (D1) toward the transmitting unit (3) cover a first integrated circuit configuration region (RN1) of the receiving unit (2) and a second integrated circuit configuration region (RN2) of the transmitting unit (3); and
two temperature equalizing plates (42) respectively disposed in the two cavity structures (GS), wherein the two temperature equalizing plates (42) are in contact with the receiving unit (2) and the transmitting unit (3), respectively.

2. The antenna device (100) according to claim 1, wherein the heat dissipation module (4) further includes two thermally conductive material layers (TC), and the two temperature equalizing plates (42) are respectively connected to the receiving unit (2) and the transmitting unit (3) through the two thermally conductive material layers (TC).

3. The antenna device (100) according to claim 1, wherein the receiving unit (2) includes a first carrier board (21) and a plurality of first beamforming integrated circuits (22), the first carrier board (21) has the first integrated circuit configuration region (RN1), the first beamforming integrated circuits (22) are disposed on the first integrated circuit configuration region (RN1), and a plurality of top surfaces of the first beamforming integrated circuits (22) are coplanar and in contact with one of the two temperature equalizing plates (42); and wherein the transmitting unit (3) includes a second carrier board (31) and a plurality of second beamforming integrated circuits (32), the second carrier board (31) has the second integrated circuit configuration region (RN2), the second beamforming integrated circuits (32) are disposed on the second integrated circuit configuration region (RN2), and a plurality of top surfaces of the second beamforming integrated circuits (32) are coplanar and in contact with another one of the two temperature equalizing plates (42).

4. The antenna device (100) according to claim 1, wherein the housing (1) has a width direction (D2) that is perpendicular to the thickness direction (D1), the housing (1) includes a plurality of heat dissipation holes (H1) at two ends of the width direction (D2), and the heat dissipation holes (H1) extend along the thickness direction (D1).

5. The antenna device (100) according to claim 4, wherein the receiving unit (2) and the transmitting unit (3) are spaced apart along the width direction (D2); wherein the heat dissipation module (4) further includes two heat pipes assemblies (43), and the two heat pipes assemblies (43) are arranged on a common side of the two metal heat dissipation components (41) and the two temperature equalizing plates (42) that is away from the receiving unit (2) and the transmitting unit (3); and wherein the two heat pipes assemblies (43) are respectively in contact with the two temperature equalizing plates (42), and a plurality of heat pipes (431) of the two heat pipes assemblies (43) are arranged along the width direction (D2).

6. The antenna device (100) according to claim 5, wherein the two heat pipes assemblies (43) respectively include two auxiliary heat dissipation components (432), and the two auxiliary heat dissipation components (432) respectively correspond in position to the heat dissipation holes (H1) disposed on two ends of the housing (1); and wherein each of the heat pipes (431) of the two heat pipes assemblies (43) includes:
a long section (4311) extending along the width direction (D2), wherein the long section (4311) is configured to contact a corresponding one of the two temperature equalizing plates (42), and the long section (4311) has a connection end adjacent to a part of the heat dissipation holes (H1); and
a short section (4312) extending from the connecting end along the thickness direction (D1), wherein the short section (4312) is configured to contact a position corresponding to one of the two auxiliary heat dissipation components (432) at a corresponding position.

7. The antenna device (100) according to claim 6, wherein each of the two auxiliary heat dissipation components (432) includes two wide side surfaces and two narrow side surfaces connected to the two wide side surfaces, and one of the two wide side surfaces faces the heat dissipation holes (H1) that are located at one of the two ends of the housing (1).

8. The antenna device (100) according to claim 6, wherein each of the heat pipes (431) includes two wide side surfaces and two narrow side surfaces connected to the two wide side surfaces, and one of the two wide side surfaces of the long section (4311) is configured to contact a corresponding one of the two temperature equalizing plates (42), and one of the two wide side surfaces of the short section (4312) is configured to contact a corresponding one of the two auxiliary heat dissipation components (432).

9. The antenna device (100) according to claim 5, wherein the two heat pipes assemblies (43) include a plurality of active heat exchangers (433), and the active heat exchangers (433) of the two heat pipes assemblies (43) respectively correspond in position to the heat dissipation holes (H1) disposed on two ends of the housing (1).

10. The antenna device (100) according to claim 6, wherein the heat dissipation module (4) further includes a plurality of thermally conductive material layers (TC), the heat pipes (431) are connected to the two temperature equalizing plates (42) and the two auxiliary heat dissipation components (432) through the thermally conductive material layers (TC).
